# EUROPÄISCHE PATENTSCHRIFT

(11) **EP 0 642 217 B1**
(45) Veröffentlichungstag und Bekanntmachung des Hinweises auf die Patenterteilung: **21.10.1998**
(21) Anmeldenummer: 94113644.2
(22) Anmeldetag: 31.08.1994
(51) Int. Cl.: H03F 1/32, H03F 3/30

(54) **Gegentaktendstufe mit einer Einstellung des Querstroms der Gegentaktendstufe**
Push-pull output stage with control of the bias current of the push-pull output stage
Etage amplificatuer de sortie avec commande du courant de polarisation de l' étage amplificateur de sortie en push-pull

(30) Priorität: 03.09.1993 DE 4329865
(43) Veröffentlichungstag der Anmeldung: 08.03.1995
(73) Patentinhaber: SIEMENS AKTIENGESELLSCHAFT, 80333 München (DE)
(72) Erfinder: Kiehl, Olivier, Dr.Ing., D-80798 München (DE)

(56) Entgegenhaltungen:
- EP-A- 0 409 476
- EP-A- 0 420 183
- IEEE JOURNAL OF SOLID-STATE CIRCUITS., Bd.25, Nr.1, Februar 1990, NEW YORK US Seiten 265 - 273, XP101876 F.N.L. OP'T EYNDE ET AL 'A CMOS LARGE-SWING LOW-DISTORTION THREE-STAGE CLASS AB POWER AMPLIFIER'

## Beschreibung

Die Erfindung betrifft eine Schaltungsanordnung zur Einstellung des Querstroms einer zwei Transistoren entgegengesetzten Leitungstyps aufweisenden Gegentaktendstufe.

Eine derartige Schaltungsanordnung ist beispielsweise aus dem Datenblatt NE/SA 5230 der Firma Valvo vom 14. November 1986 bekannt. Dabei wird die Spannung über zwei in Reihe geschalteten, von einem Referenzstrom durchflossenen Dioden mit der Summe der Basis-Emitter-Spannungen der Gegentaktendstufentransistoren verglichen und davon abhängig der Querstrom der Gegentaktendstufe eingestellt. Da die Basis-Emitter-Spannungen der Endstufentransistoren proportional sind zum Logarithmus des sie durchfließenden Stromes, wird demgemäß das Produkt der jeweils durch die Endstufentransistoren fließenden Ströme gegenüber dem Logarithmus des Referenzstroms konstant gehalten. Um die Temperaturabhangigkeit, mit der der logarithmische Zusammenhang zwischen Basis-Emitter-Spannung und Kollektorstrom bei einem Transistor behaftet ist, teilweise zu kompensieren, weisen die Dioden eine entsprechende Temperaturabhängigkeit auf. Zur Erzielung einer höheren Genauigkeit wäre jedoch ein erheblicher, zusätzlicher Schaltungsaufwand notwendig. Darüber hinaus wird bei der bekannten Schaltungsanordnung die Genauigkeit dadurch weiter herabgesetzt, daß sich Laständerungen, die den Strom bei nur einem der beiden Endstufentransistoren beeinflussen, sich infolge der aus der Logarithmierung und anschließenden Addition sich ergebende Produktbildung insgesamt auf die Einstellung des Querstroms auswirken.

Aus der EP-A-0 420 183 ist eine Push-Pull-Schaltung bekannt geworden, die eine Steuerschaltung aufweist, um den Strom durch die Push-Pull-Transistoren konstant zu halten. Dazu ermittelt die Steuerschaltung den Strom durch die Push-Pull-Transistoren und erzeugt daraus ein Signal, das über eine Pegelschiebeschaltung auf die Steueranschlüsse der Push-Pull-Transistoren wirkt.

Aus dem Artikel "A CMOS Large-Swing Low-Distortion Three-Stage Class AB Power Amplifier" von F.N.L. Op't Eynde et al, veröffentlicht in IEEE Journal of Solid-State Circuits, 25. Februar 1990, Nr. 1 ist ein dreistufiger Leistungsverstärker vom Typ Push-Pull bekannt geworden. Dieser Verstärker wird im Common-Mode betrieben. Es ist eine Steuerschaltung beschrieben, mit der der Ruhestrom durch die Push-Pull-Transistoren gesteuert werden kann. Dieser wird auf einen Referenzstrom bezogen.

Aufgabe der Erfindung ist es, eine Gegentaktendstufe mit einer Schaltungsanordnung zur Einstellung des Querstroms durch zwei Transistoren der Gegentaktendstufe anzugeben, die bei geringem schaltungstechnischem Aufwand eine höhere Genauigkeit aufweist.

Die Aufgabe wird gelöst mit einer Gegentaktendstufe mit den Merkmalen der Patentansprüche 1 oder 2.

Bei einer Ausführungsform der Erfindung enthält die Vergleichsschaltung eine weitere Gegentaktendstufe, deren Querstrom ermittelt und mit einem Referenzstrom verglichen wird, wobei davon abhängig die Last gesteuert wird.

Bei einer anderen Ausführungsform enthält die Vergleichsschaltung zwei entgegengesetzt gleich große Ströme liefernde Konstantstromquellen, die jeweils einen von zwei weiteren Transistoren entgegengesetzten Leitungstyps speisen, wobei die weiteren Transistoren jeweils durch eine der gesteuerten Stromquellen angesteuert werden und jeweils der Spannungsabfall an den Laststrecken der weiteren Transistoren zur Ansteuerung der Feldeffekttransistoren vorgesehen ist.

Die Erfindung wird nachfolgend anhand der in den Figuren der Zeichnung dargestellten Ausführungsbeispiele näher erläutert. Es zeigt:
- Figur 1: eine erste Ausführungsform einer erfindungsgemäßen Schaltungsanordnung und
- Figur 2: eine zweite Ausführungsform einer erfindungsgemäßen Schaltungsanordnung.
- Figur 3: eine dritte Ausführungsform einer erfindungsgemäßen Schaltungsanordnung.

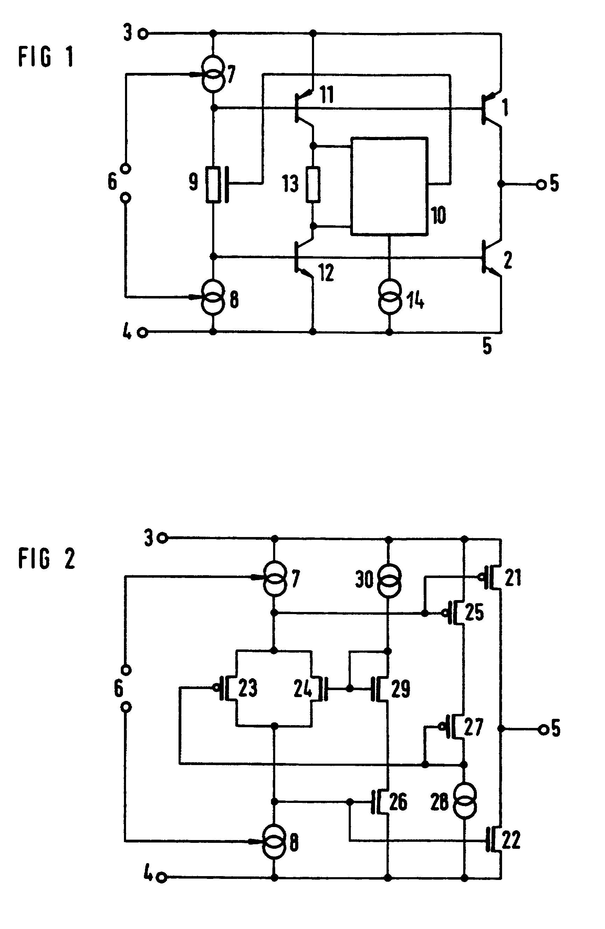

Bei dem Ausführungsbeispiel nach Figur 1 ist eine aus Bipolartransistoren 1, 2 aufgebaute Gegentaktendstufe vorgesehen. Der Transistor 1 ist dabei ein pnp-Typ, dessen Emitter an ein positives Versorgungspotential 3 angeschlossen ist und dessen Kollektor mit dem Kollektor des Transistors 2 vom npn-Typ verbunden ist. Der Emitter des Transistors 2 ist entsprechend an ein negatives Versorgungspotential 4 angeschlossen. An den miteinander gekoppelten Kollektoren der Transistoren 1 und 2 ist ein Ausgangssignal 5 abgreifbar, das zu einem differenziellen Eingangssignal 6 proportional ist.

Die Basis-Emitter-Strecken der Transistoren 1 und 2 werden dabei jeweils durch ihnen parallel geschaltete, durch das Eingangssignal 6 angesteuerte und jeweils entgegengesetzt gleich große Ströme liefernde Stromquellen 7 und 8 gespeist. Zwischen die Basen der Transistoren 1 und 2 ist eine steuerbarere Last 9 geschaltet, die von einer Auswerteeinrichtung 10 angesteuert wird. Die Auswerteeinheit 10 stellt deren Widerstand 9 dahingehend ein, daß der durch eine Vergleichsendstufe fließende Querstrom gleich einem durch eine Stromquelle 14 erzeugten Referenzstrom ist. Die Vergleichsendstufe besteht aus zwei Bipolartransistoren, nämlich einem pnp-Transistor 11 und einem npn-Transistor 12, deren Basis- und Emitteranschlüsse jeweils mit den Basis- bzw. Emitteranschlüssen der Transistoren 1 und 2 verbunden sind. Zwischen die Kollektoren der Transistoren 11 und 12 ist eine Strommeßeinrichtung beispielsweise in Form eines Widerstandes 13 geschaltet, wobei der durch den Querstrom hervorgerufene Spannungsabfall über den Widerstand 13 durch die Auswerteeinrichtung 10 mit einem durch den Referenzstrom hergerufenen Spannungsabfall an einem identischen, nicht gezeigten Widerstand verglichen wird.

Bei dem Ausführungsbeispiel nach Figur 2 enthält die Gegentaktendstufe einen MOS-Feldeffekttransistor 21 vom p-Kanal-Typ, dessen Sourceanschluß mit dem positiven Versorgungspotential 3 verbunden ist, und einen MOS-Feldeffekttransistor 22 vom n-Kanal-Typ, dessen Sourceanschluß mit dem negativen Versorgungspotential 4 verbunden ist. An den miteinander gekoppelten Drainanschlüssen beider Transistoren ist das Ausgangssignal 5 abnehmbar. Die durch das Eingangssignal 6 angesteuerten Stromquellen 7 und 8 sind bei dieser Ausführungsform jeweils zwischen die Gate- und Sourceanschlüsse der Transistoren 21 und 22 geschaltet. Dabei werden als steuerbarer Widerstand zwei MOS-Transistoren 23 und 24 eingesetzt, die von unterschiedlichem Leitungstyp sind und deren Drain-Source-Strecken einander antiparallel geschaltet sind.

Die Gate- und Sourceanschlüsse eines MOS-Feldeffekttransistors 25 vom p-Kanal-Typ und eines MOS-Feldeffekttransistors 26 vom n-Kanal-Typ sind dabei jeweils mit den Gate- und Sourceanschlüssen der Transistoren 21, bzw. 22 verbunden. Der Drainanschluß des Transistors 25 ist unter Zwischenschaltung einer Diode 27 in Durchlaßrichtung und einer Stromquelle an das negative Versorungspotential 4 angeschlossen. In gleicher Weise ist der Drainanschluß des Transistors 26 über eine Diode 29 in Durchlaßrichtung und eine Stromquelle 30 mit dem positiven Versorgungspotential 3 verbunden. Der Abgriff zwischen der Diode 27 und der Stromquelle 28 ist mit dem Gateanschluß des Transistors 23 vom p-Kanal-Typ und der Abgriff zwischen der Stromquelle 30 und der Diode 29 mit dem Gateanschluß des Transistors 24 vom n-Kanal-Typ gekoppelt. Für den Fall, daß eine Zunahme der Verzerrungen tolerierbar ist, können die beiden Dioden 27 und 29 auch entfallen und durch einen Kurzschluß ersetzt werden. Erfindungsgemäß wird also in beiden gezeigten Ausführungsbeispielen die Bestimmung des Querstroms nicht direkt aus der eigentlichen Gegentaktendstufe abgeleitet, sondern aus einer Vergleichsschaltung, die beispielsweise aus einer ähnlichen Gegentaktendstufe besteht oder gemäß Figur 2 aus einer Anordnung, bei der die Vergleichsgegentaktendstufe in zwei Zweige aufgespaltet wird, von denen jeweils ein Zweig einem der Endstufentransistoren entspricht. Demnach haben die Transistoren 11 und 1 sowie 12 und 2 bei der Anordnung nach Figur 1 ein proportionales Verhalten, während bei Figur 2 die Transistoren 21 und 25 sowie 22 und 26 ein proportionales Verhalten aufweisen. Proportionale Verhalten bedeutet, daß der Querstrom der Vergleichsgegentaktendstufe um einen bestimmten Faktor kleiner sein kann als der der eigentlichen Gegentaktendstufe bzw. daß die durch die Stromquellen 28 und 30 eingeprägten und zueinander gleichen Ströme ebenfalls um einen bestimmten Faktor kleiner sind als der Querstrom der eigentlichen Gegentaktendstufe und Schwankungen sich im gleichen Verhältnis auswirken. Dadurch wird der Stromverbrauch der gesamten Anordnung wesentlich herabgesetzt. Wie insbesondere bei dem Ausführungsbeispiel nach Figur 2 ersichtlich ist, ist mit geringem Schaltungsaufwand eine schnelle und stabile Einstellung des Querstroms einer Gegentaktendstufe mit der erfindungsgemäßen Schaltungsanordnung möglich.

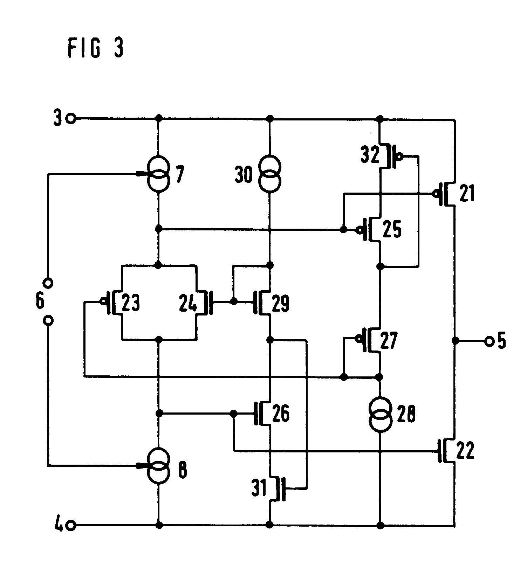

Das Ausführungsbeispiel nach Figur 3 ilst gegenüber Figur 2 dahingehend abgeändert, daß der Sourceanschluß des Transistors 25 an den Drainanschluß eines MOS-Feldeffekttransistors 32 vom p-Kanal-Typ gelegt ist, dessen Sourceanschluß an das positive Versorgungspotential 3 und dessen Gateanschluß an den Drainanschluß des Transistors 25 angeschlossen ist. Dementsprechend ist der Sourceanschluß des Transistors 26 mit dem Drainanschluß eines MOS-Feldeffekttransistors 31 vom n-Kanal-Typ verbunden, dessen Sourceanschluß mit dem negativen Versorgungspotential 4 und dessen Gateanschluß mit dem Drainanschluß des Transistor 26 gekoppelt ist. Durch diese Maßnahmen wird eiine größere Verzerrungsarmut erreicht.

Schließlich weisen bevorzugt die Transistoren 22, 26, 31 untereinander, die Transistoren 24 und 29 untereinander, die Transistoren 27, 23 untereinander sowie die Transistoren 21, 25 und 37 untereinander jeweils gleiche Kanallänge auf. Dabei bewegen sich die Verhältnisse der Kanalweiten der Transistoren 29 und 24 zueinander, der Transistoren 27 und 23 zueinander, der Transistoren 26 und 31 zueinander sowie der Transistoren 25 und 32 zueinander im Bereich von 1/2 bis 1/4. Auch sollten die Ruheströme der Stromquelle 7, 30, 8 und 28 in der gleichen Größenordnung liegen.

## Patentansprüche

1. Gegentaktendstufe, die durch ein Eingangssignal (6) angesteuert wird, mit einer Schaltungsanordnung zur Einstellung des Querstroms, der durch zwei Transistoren (21, 22) entgegengesetzten Leitungstyps der Gegentaktendstufe fließt,
wobei über ein Stellglied (7, 8, 23, 24) die Querströme der Gegentaktendstufe (21, 22) und einer Vergleichsschaltung (25 bis 30) dahingehend eingestellt werden, daß eine ihr zugeführte, aus der Vergleichsschaltung (25 bis 30) abgeleitete und zu dem Querstrom der Gegentaktendstufe (21, 22) proportionale Größe mit einer Referenzgröße übereinstimmt,
wobei als Stellglied zwei durch das Eingangssignal (6) gesteuerte, entgegengesetzt gleich große Ströme liefernde Stromquellen (7, 8) vorgesehen sind, die über eine steuerbare Last (23, 24) miteinander gekoppelt sind, wobei die Stromquellen (7, 8) ihrerseits jeweils einen der beiden Transistoren (21, 22) der Gegentaktendstufe und die Vergleichsschaltung (25 bis 30) ansteuern,
wobei die steuerbare Last (23, 24) aus zwei zueinander gegenphasig angesteuerten Feldeffekttransistoren (23, 24) entgegengesetzten Leitungstyps besteht, deren Laststrecken einander antiparallel geschaltet sind,
wobei die Vergleichsschaltung (25 bis 30) zwei entgegengesetzte gleich große Ströme liefernde Konstantstromquellen (28, 30) enthält, die jeweils einen von zwei weiteren Transistoren (25, 26) entgegengesetzten Leitungstyps speisen, wobei die weiteren Transistoren (25, 26) jeweils durch eine der gesteuerten Stromquellen (7, 8) angesteuert werden und wobei jeweils die Spannungsabfälle an den Laststrecken der weiteren Transistoren (25, 26) zur Ansteuerung jeweils der Feldeffektransistoren (23, 24) der Last (23, 24) vorgesehen sind,
wobei in Reihe zu den Laststrecken der weiteren Transistoren (25, 26) die Laststrecke jeweils eines zusätzlichen Transistors (32, 31) des jeweils gleichen Leitungstyps geschaltet ist, der durch den Spannungsabfall über der Laststrecke des jeweils zugehörigen weiteren Transistors (25, 26) angesteuert wird.

2. Gegentaktendstufe, die durch ein Eingangssignal (6) angesteuert wird, mit einer Schaltungsanordnung zur Einstellung des Querstroms, der durch zwei Transistoren (21, 22) entgegengesetzten Leitungstyps der Gegentaktendstufe fließt,
wobei über ein Stellglied (7, 8, 9) die Querströme der Gegentaktendstufe (1, 2) und einer Vergleichsschaltung (11, 12) dahingehend eingestellt werden, daß eine ihr zugeführte, aus der Vergleichsschaltung (11, 12) abgeleitete und zu dem Querstrom der Gegentaktendstufe (1, 2) proportionale Größe mit einer Referenzgröße übereinstimmt,
wobei als Stellglied zwei durch das Eingangssignal (6) gesteuerte, entgegengesetzt gleich große Ströme liefernde Stromquellen (7, 8) vorgesehen sind, die über eine steuerbare Last (9) miteinander gekoppelt sind, wobei die Stromquellen (7, 8) ihrerseits jeweils einen der beiden Transistoren (1, 2) der Gegentaktendstufe und die Vergleichsschaltung (11, 12) ansteuern,
wobei die Vergleichsschaltung eine weitere Gegentaktendstufe (11, 12) aufweist, deren Querstrom durch eine Auswerteeinheit (10, 13, 11) ermittelt und mit einem Referenzstrom verglichen wird, und davon abhängig die Last (9) gesteuert wird.

## Claims

1. Push-pull output stage which is driven by an input signal (6), having a circuit arrangement for setting the parallel-path current which flows through two transistors (21, 22) of opposite conduction types of the push-pull output stage,
in which, via an actuator (7, 8, 23, 24), the parallel-path currents of the push-pull output stage (21, 22) and of a comparison circuit (25 to 30) are set to the effect that a quantity which is fed to it, is derived from the comparison circuit (25 to 30) and is proportional to the parallel-path current of the push-pull output stage (21, 22) corresponds to a reference quantity,
in which the actuator provided is in the form of two current sources (7, 8), which are controlled by the input signal (6), supply opposite currents of the same magnitude and are coupled to one another via a controllable load (23, 24), the current sources (7, 8) for their part respectively driving one of the two transistors (21, 22) of the push-pull output stage and the comparison circuit (25 to 30),
in which the controllable load (23, 24) comprises two field-effect transistors (23, 24) of opposite conduction types, which transistors are driven in antiphase with respect to one another and the load paths of which transistors are reverse-connected in parallel with one another,
in which the comparison circuit (25 to 30) contains two constant-current sources (28, 30), which supply opposite currents of the same magnitude and respectively feed one of two further transistors (25, 26) of opposite conduction types, the further transistors (25, 26) respectively being driven by one of the controlled current sources (7, 8) and the respective voltage drops across the load paths of the further transistors (25, 26) being provided for driving the respective field-effect transistors (23, 24) of the load (23, 24),
in which the load path of a respective additional transistor (32, 31) of the respectively identical conduction type is connected in series with the load paths of the further transistors (25, 26), which additional transistor is driven by the voltage drop across the load path of the respectively associated further transistor (25, 26).

2. Push-pull output stage which is driven by an input signal (6), having a circuit arrangement for setting the parallel-path current which flows through two transistors (21, 22) of opposite conduction types of the push-pull output stage,
in which, via an actuator (7, 8, 9), the parallel-path currents of the push-pull output stage (1, 2) and of a comparison circuit (11, 12) are set to the effect that a quantity which is fed to it, is derived from the comparison circuit (11, 12) and is proportional to the parallel-path current of the push-pull output stage (1, 2) corresponds to a reference quantity,
in which the actuator provided is in the form of two current sources (7, 8), which are controlled by the input signal (6), supply opposite currents of the same magnitude and are coupled to one another via a controllable load (9), the current sources (7, 8) for their part respectively driving one of the two transistors (1, 2) of the push-pull output stage and the comparison circuit (11, 12),
in which the comparison circuit has a further push-pull output stage (11, 12), the parallel-path current of which is determined by an evaluation unit (10, 13, 11) and compared with a reference current, and the load (9) is controlled in dependence on this.

## Revendications

1. Etage amplificateur de sortie, qui est commandé par un signal d'entrée (6), qui comporte un montage pour le réglage du courant de polarisation qui passe par deux transistors (21, 22) de types de conductivité opposés de l'étage amplificateur de sortie, dans lequel
par l'intermédiaire d'un composant de réglage (7, 8, 23, 24), les courants de polarisation de l'étage amplificateur de sortie (21, 22) et d'un circuit de comparaison (25 à 30) sont réglés de telle sorte qu'une grandeur, qui est envoyée à cet étage, qui est déduite du circuit de comparaison (25 à 30) et qui est proportionnelle au courant de polarisation de l'étage amplificateur de sortie (21, 22), est égale à une grandeur de référence,
il est prévu,comme composant de réglage, deux sources de courant (7, 8) qui sont commandées par le signal d'entrée (6), qui fournissent des courants de grandeurs identiques mais opposées et qui sont reliées entre elles par l'intermédiaire d'une charge (23, 24) pouvant être commandée, les sources de courant (7, 8) commandant quant à elles chacune un des deux transistors (21, 22) de l'étage amplificateur de sortie et le circuit de comparaison (25 à 30),
la charge (23, 24) pouvant être commandée est constituée de deux transistors à effet de champ (23, 24) de types de conductivité opposés qui sont commandés en opposition de phase l'un par rapport à l'autre et cent les voies de charge sont branchées l'une par rapport à l'autre selon un montage tête-bêche,
le circuit de comparaison (25 à 30) comporte deux sources de courant constant (28, 30), qui fournissent des courants de grandeurs identiques mais opposées et qui alimentent chacune un des deux autres transistors (25, 26) de types de conductivité opposés, les autres transistors (25, 26) étant commandés chacun par une des sources de courant commandées (7, 8) et les chutes de tension aux voies de charge des autres transistors (25, 26) étant prévues pour la commande des transistors à effet de champ (23, 24) de la charge (23, 24),
les voies de charge de transistors supplémentaires (32, 31) de types de conductivité respectivement identiques sont branchées respectivement en série avec les voies de charge des autres transistors (25, 26), ces transistors supplémentaires étant commandés par les chutes de tension à la voie de charge respective de l'autre transistor (25, 26) associé.

2. Etage amplificateur de sortie, qui est commandé par un signal d'entrée (6), qui comporte un montage pour le réglage du courant de polarisation qui passe par deux transistors (21, 22) de types de conductivité opposés de l'étage amplificateur de sortie, dans lequel
par l'intermédiaire d'un composant de réglage (7, 8, 9), les courants de polarisation de l'étage amplificateur de sortie (1, 2) et d'un circuit de comparaison (11, 12) sont réglés de telle sorte qu'une grandeur, qui est envoyée à cet étage, qui est déduite du circuit de comparaison (11, 12) et qui est proportionnelle au courant de polarisation de l'étage amplificateur de sortie (1, 2), soit égale à une grandeur de référence,
comme composant de réglage, il est prévu deux sources de courant (7, 8) qui sont commandées par le signal d'entrée (6), qui fournissent des courants de grandeurs identiques mais opposées et qui sont reliées entre elles par l'intermédiaire d'une charge (9) pouvant être commandée, les sources de courant (7, 8) commandant quant à elles chacune un des deux transistors (1, 2) de l'étage amplificateur de sortie et le circuit de comparaison (11, 12),
le circuit de comparaison comporte un autre étage amplificateur de sortie (11, 12), dont le courant de polarisation est déterminé par une unité d'exploitation (10, 13, 11) et est comparé à un courant de référence, et la charge (9) est commandée en fonction de cette comparaison.
